# EUROPÄISCHE PATENTSCHRIFT

(11) **EP 2 047 014 B1**
(45) Veröffentlichungstag und Bekanntmachung des Hinweises auf die Patenterteilung: **25.12.2013**
(21) Anmeldenummer: 07787506.0
(22) Anmeldetag: 13.07.2007
(51) Int. Cl.: C30B 29/06, C01B 33/037, B02C 23/08, C30B 15/00, B02C 21/00

(54) **VERFAHREN UND VORRICHTUNG ZUR HERSTELLUNG VON KLASSIERTEM POLYKRISTALLINEN SILICIUMBRUCH IN HOHER REINHEIT**
METHOD AND DEVICE FOR PRODUCING CLASSIFIED HIGH-PURITY POLYCRYSTALLINE SILICON FRAGMENTS
PROCÉDÉ ET DISPOSITIF POUR PRÉPARER UN FRAGMENT DE SILICIUM POLYCRISTALLIN CALIBRÉ DE HAUTE PURETÉ

(30) Priorität: 28.07.2006 DE 102006035081
(43) Veröffentlichungstag der Anmeldung: 15.04.2009
(73) Patentinhaber: Wacker Chemie AG, 81737 München (DE)
(72) Erfinder: SCHÄFER, Marcus, 83278 Traunstein (DE); PECH, Reiner, 84524 Neuötting (DE); WOCHNER, Hanns, 84489 BURGHAUSEN (DE)
(74) Vertreter: Fritz, Helmut
(86) Internationale Anmeldenummer: PCT/EP2007/057238
(87) Internationale Veröffentlichungsnummer: WO 2008/012215

(56) Entgegenhaltungen:
- EP-A- 0 137 306
- EP-A- 0 497 497
- EP-A- 1 338 682
- EP-A- 1 391 252
- DE-A1- 19 529 518
- DE-A1- 19 741 465
- US-A- 5 165 548
- US-A1- 2006 070 569
- US-B1- 6 309 467

## Beschreibung

Die Erfindung betrifft ein Verfahren und eine Vorrichtung zur Herstellung von klassiertem polykristallinen Silicium in hoher Reinheit.

Hochreines polykristallines Silicium, im Folgenden als Polysilicium bezeichnet, dient u. a. als Ausgangsmaterial für die Herstellung von elektronischen Bauteilen und Solarzellen. Es wird durch thermische Zersetzung eines siliciumhaltigen Gases oder eines siliciumhaltigen Gasgemisches gewonnen. Dieser Prozess wird als Abscheidung aus der Dampfphase (CVD, chemical vapor deposition) bezeichnet. In großem Maßstab wird dieser Prozess in so genannten Siemens-Reaktoren realisiert. Das Polysilicium fällt dabei in Form von Stäben an. Die Polysilicium-Stäbe werden ausgebaut und mittels händischer Verfahren oder maschinell zerkleinert. Der so erhaltene Polysilicium-Grobbruch wird unter Einsatz von Brechern weiter zerkleinert. Mechanische Brechverfahren sind beispielsweise in EP 1 338 682 A2 beschrieben. Anschließend wird der Polysilicium-Bruch mit einem Siebverfahren, z. B. einem mechanischen Siebverfahren, wie aus EP 1 043 249 B1 bekannt, oder einer optischen Sortierung, wie z. B. aus US 6,265,683 B1 bekannt, klassiert. Der PolysiliciumBruch wird dabei mittels Fördervorrichtungen, wie z. B. Förderbändern, Förderrinnen, Schwingförderern oder Transportbehältern von einer Vorrichtung zur nächsten transportiert. Dabei wird jeder Bearbeitungsschritt des Polysiliciums (z. B. das Brechen oder das Sortieren) aufgrund der jeweiligen spezifischen Aufgabenstellungen individuell angepasst. Insbesondere wurden dabei die Anforderungen an die für die Vorrichtung eingesetzten Werkstoffe für jeden Bearbeitungs- oder Transportschritt einzeln angepasst. Für die einzelnen Vorrichtungen wurde dabei vorzugsweise die mit dem Polysilicium-Bruch in Kontakt kommenden Oberflächen aus einem für den Polysilicium-Bruch kontaminationsarmen Werkstoff oder aus Silicium gestaltet. Ferner ist es Stand der Technik, wenn eine einzelne Vorrichtung aus einem anderen Werkstoff besteht, den Polysilicium-Bruch mit einem Reinigungsverfahren aufzureinigen (EP 1 338 682 A2 oder DE 197 41 465). Diese Reinigungsverfahren sind je nach eingesetzter Chemie unterschiedlich gut in der Lage, die das Polysilicium verunreinigenden Metall von der Oberfläche des Polysiliciums zu entfernen.

Aufgabe der vorliegenden Erfindung ist es, ein einfaches und kostengünstiges Verfahren zur Herstellung von hochreinem klassierten Polysilicium-Bruch zur Verfügung zu stellen.

Die Aufgabe wird gelöst durch ein Verfahren, bei dem ein Polysilicium aus dem Siemens-Verfahren mittels einer Vorrichtung umfassend Zerkleinerungswerkzeuge und einer Siebvorrichtung zerkleinert und klassiert wird und der so erhaltene Polysilicium-Bruch mittels eines Reinigungsbades gereinigt wird, dadurch gekennzeichnet, dass der Brecher und die Siebvorrichtung durchgängig eine mit dem Polysilicium in Kontakt kommende Oberfläche aus niedriglegiertem Stahl besitzen, und der Polysilicium-Bruch nur mit solchen Fremdpartikeln verunreinigt wird, welche anschließend gezielt durch das Reinigungsbad entfernt werden.

Bei dem Polysilicium aus dem Siemens-Verfahren handelt es sich entweder um einen Polysilicium-Grobbruch oder einen Polysilicium-Stab aus dem Siemens-Reaktor.

Bevorzugt bestehen auch die Oberflächen aller Vorrichtungen, die beim Ausbau des Polysilicium-Stabes aus dem Siemens-Reaktor sowie beim Transport zum Brechen mit dem Polysilicium in Kontakt kommen, durchgängig aus niedriglegiertem Stahl, welcher den Polysilicium-Bruch nur mit solchen Fremdpartikeln verunreiniet, welche anschließend gezielt durch das Reinigungsbad entfernt werden. Das erfindungsgemäße Verfahren umfasst daher vorzugsweise auch den Ausbau eines Polysilicium-Stabes aus einem Siemens Reaktor sowie seinen Transport zum Brechen.

Bevorzugt bestehen auch die Oberflächen aller Vorrichtungen, die bei dem Transport des klassierten zerkleinerten Polysilicium-Bruchs zum Verpacken sowie beim Verpacken des klassierten zerkleinerten Polysilicium-Bruchs verwendet werden durchgängig aus niedriglegiertem Stahl, welcher den Polysilicium-Bruch nur mit solchen Fremdpartikeln verunreinigt, welche anschließend gezielt durch das Reinigungsbad entfernt werden. Das erfindungsgemäße Verfahren umfasst daher vorzugsweise auch den Transport des klassierten zerkleinerten Polysiliciums sowie das Verpacken des klassierten zerkleinerten Bruchs.

Insbesondere bevorzugt wird der gereinigte und klassierte Polysilicium-3ruch sofort händisch oder automatisch in PE-Doppelbeutel verpackt, wie in EP-B-1 334 907 beschrieben.

Als zerkleinerungswerkzeuge werden vorzugsweise Brecher eingesetzt. Ferner kann im erfindungsgemäßen Verfahren ein Vorzerkleinerer, wie er in DE 10 2005 019 873 beschrieben ist, eingesetzt werden. Die Oberfläche des Vorzerkleinerers sowie die Oberfläche ggf. genutzter weiterer Hilfsmittel zur Bearbeitung, die mit dem Polysilicium in Kontakt kommen, sind dann e-benfalls aus dem Werkstoff gefertigt, welcher den PolysiliciumBruch nur mit solchen Fremdpartikeln verunreinigt, welche anschließend gezielt durch das Reinigungsbad entfernt werden.

Im Gegensatz zum bekannten Verfahren versucht das erfindungsgemäße Verfahren nicht, bei der Zerkleinerung eine metallische Verunreinigung des Polysilicium-Bruchs zu vermeiden, sondern es kombiniert eine über alle Anlagen durchgängig gezielte Verunreinigung des Polysilicium-Bruchs mit einem Material, welches einfach durch das Reinigungsbad entfernt werden kann. Demgegenüber wurde bei den bekannten Verfahren darauf geachtet, die Kontamination des zu bearbeitenden Materials (z. B. des Polysiliciums) bei jedem Bearbeitungsschritt so gering wie möglich zu halten. Man ging dabei davon aus, dass die Reinigung in Bezug auf Kosten und Qualität umso günstiger ist, je niedriger die Eingangskontamination des zu reinigenden Materials ist.

Die Erfindung betrifft somit auch ein Verfahren zur Herstellung von hochreinem klassierten Polysilicium-Bruch aus einem Polysilicium-Stab bei dem alle mit dem Polysilicium in Berührung kommenden Oberflächen durchgängig aus einem Werkstoff ausgeführt sind, der in der nachfolgenden Reinigung einfach und vollständig von dem klassierten Polysilicium-Bruch entfernt wird.

"Durchgängig eine mit dem Polysilicium in Kontakt kommende Oberfläche aus einem Werkstoff" bedeutet im Sinne der vorliegenden Erfindung, dass mindestens 90 %, vorzugsweise mindestens 95 % der Kontamination des Polysilicium-Bruchs vor der Reinigung (ist gleich Eingangskontamination für das Reinigungsverfahren) von diesem Werkstoff verursacht wird. Besonders bevorzugt bedeutet diese Formulierung, dass die mit dem PolysilciumBruch in Berührung kommenden Oberflächen aller Vorrichtungen aus dem genannten Werkstoff bestehen.

Überraschenderweise wurde festgestellt, dass auch bei einer sehr hohen Eingangskontamination des klassierten Polysilicium-Bruchs, mit einem kostengünstigen Reinigungsbad eine hohe Reinheit an metallischen Verunreinigungen und damit eine hohe Qualität des gereinigten klassierten Polysilicium-Bruchs erzielt werden kann, wenn die Kontamination des Polysilicium-Bruchs im Rahmen der genannten Verfahren gezielt derart erfolgt, dass sie mittels eines auf diese Kontamination abgestimmten Reinigungsbades entfernt werden kann.

Die gezielte Kontamination des Polysilicium-Bruchs wird dadurch erreicht, dass der Werkstoff für die Oberfläche der das Polysilicium berührenden Teile der genannten Vorrichtungen vorzugsweise ausgewählt ist aus der Gruppe verschleißarmer Kunststoff, Edelstahl, Hartmetall, Keramik, Quarz, niedriglegierter Stahl, mittellegierter Stahl, hochlegierter Stahl und Silicium.

Besonders bevorzugt handelt es sich bei dem Werkstoff um einen niedriglegierten Stahl mit einem Legierungsgehalt kleiner als 5 Gew.% oder um einen mittellegierten Stahl mit einem Legierungsgehalt ≥ 5 Gew.% aber kleiner als 10 Gew.% oder um einen höherlegierten Stahl mit einem Legierungsgehalt ≥ 10 Gew.% oder um ein Hartmetall, bevorzugt Wolframcarbid, oder um Silicium, bevorzugt Polysilicium.

Aus Kostengründen insbesondere handelt es sich bevorzugt um einen niedriglegierten Stahl mit einem Legierungsgehalt kleiner als 5 Gew.%. Überraschenderweise konnte ein solcher Werkstoff für alle genannten Vorrichtungen, insbesondere auch für Transportkisten oder auch große Gussteile, z. B. eines Walzenbrechers, ohne fertigungstechnische oder mechanische Einschränkungen durchgängig eingesetzt werden.

Ein niedriglegierter Stahl ist vorzugsweise ein Stahl mit einem Gesamtlegierungsgehalt von < 5 Gew% der Elemente Cr, Co, Mn, Ni, Si, W, Al, Be, Cu, Mo, Nb, Pb, Ta, Ti, V, Zr, P, S, N, Ce und B.

Im erfindungsgemäßen Verfahren sind die den Polysilicium-Bruch verunreinigenden Bestandteile der Vorrichtung zur Bearbeitung des Bruches gezielt auf das Reinigungsbad abgestimmt. Dies ermöglicht sowohl Vorteile hinsichtlich der Qualität des Produktes (Oberflächenkontamination nach Reinigung) als auch hinsichtlich der Reinigungskosten des klassierten Polysilicium-Bruchs sowie der Bearbeitungskosten für die Zerkleinerung und Klassierung.

Vorzugsweise umfasst das Reinigungsbad zur Reinigung des Polysilicium-Bruchs eine Vorreinigung in zumindest einer Stufe mit einer oxidierenden Reinigungslösung, die die Verbindungen Fluorwasserstoffsäure, Chlorwasserstoffsäure und Wasserstoffperoxid enthält, eine Hauptreinigung in einer weiteren Stufe mit einer Reinigungslösung, die Salpetersäure und Fluorwasserstoffsäure enthält, und eine Hydrophilierung des Polysilicium-Bruchs mittels einer weiteren Stufe mit einer oxidierenden Reinigungslösung.

Die Erfindung umfasst auch ein Verfahren zur Herstellung von hochreinem klassierten Polysilicium-Bruch aus einer Polysilicium-Stange aus der Siemensabscheidung, bei dem die Polysilicium-Stange mit manuellen Hilfsmitteln (z. B. Ausbauhilfen, Handhammer, Transportkisten) und maschinellen Vorrichtungen, wie einem Vorzerkleinerer, einem oder mehreren Brechern, einer oder mehreren Sortiereinrichtungen, einer oder mehreren Förderrinnen zerkleinert und klassiert wird und der so erhaltene Polysilicium-Bruch mittels eines Reinigungsbades gereinigt wird, dadurch gekennzeichnet, dass alle Oberflächen der manuellen Hilfsmitteln und der maschinellen Vorrichtungen, die für 90 %, vorzugsweise 95 %, insbesondere bevorzugt 100 % der Eingangskontamination zur Reinigung verantwortlich sind, aus einem Werkstoff bestehen, welcher den Polysilicium-Bruch nur mit solchen Fremdpartikeln verunreinigt, welche anschließend gezielt durch das Reinigungsbad entfernt werden.

Im erfindungsgemäßen Verfahren wird vorzugsweise der in DE 197 41 465 A1 beschriebene Reinigungsprozess oder ein Reinigungsverfahren, wie in den Beispielen der vorliegenden Anmeldung beschrieben, in Kombination mit Vorrichtungen, deren mit dem Polysilicium-Bruch in Kontakt kommende Oberfläche aus einem niedriglegierten Stahl mit einem Legierungsgehalt kleiner als 5 Gew.%. besteht eingesetzt. Überraschenderweise war in dieser Kombination auch bei Einsatz dieses kostengünstigen Werkstoffs der Polysilicium-Bruch trotz einer sehr hohen Eingangskontamination sehr gut zu reinigen.

Auch durch Reinigungsbäder unter Nutzung anderer Verfahren des Stands der Technik (wie z. B. aus EP 1 338 682 A2, S. 8, Absatz 0054 bis 0058 oder aus US 6,309,467 bekannt) sind kostengünstigere und bessere Reinigungsergebnisse zu erzielen, wenn bei der Behandlung, insbesondere beim Brechen, Klassieren und Fördern des Polysiliciums darauf geachtet wird, dass durchgängig Vorrichtungen eingesetzt werden, deren Oberfläche aus einem Material besteht, welches mittels des jeweiligen Reinigungsbades gezielt vom Polysilicium entfernt werden kann.

Die Erfindung betrifft ferner eine Vorrichtung zur Durchführung des erfindungsgemäßen Verfahrens umfassend Teilvorrichtungen zum Brechen, Fördern, Klassieren und Reinigen von Polysilicium, bei dem die Oberfläche aller zum Brechen, Fördern und Klassieren des Polysiliciums verwendeten Teilvorrichtungen durchgängig aus einem Werkstoff ausgeführt ist, der in der nachfolgenden Reinigung des klassierten Polysilicium-Bruchs einfach und vollständig entfernt werden kann.

Für die erfindungsgemäße Vorrichtung gelten die zum Verfahren gemachten Angaben analog.

Besonders bevorzugt umfasst die erfindungsgemäße Vorrichtung eine Aufgabeeinrichtung für einen Polysilicium-Grobbruch in eine Brecheranlage, die Brecheranlage, eine Fördervorrichtung von der Brecheranlage zu einer Sortieranlage und die Sortieranlage zum Klassieren des Polysilicium-Bruchs.

Besonders bevorzugt umfasst die Brechanlage Walzenbrecher oder Backenbrecher, bevorzugt Walzenbrecher, besonders bevorzugt Stachelwalzenbrecher.

Besonders bevorzugt besteht die Sortieranlage aus einer mehrstufigen mechanischen Siebanlage und einer mehrstufigen optoelektronischen Trennanlage.

Insbesondere bevorzugt ist ferner ein Vorzerkleinerer ein Teil der Vorrichtung. Der Vorzerkleinerer besteht vorzugsweise aus einer Unterlage sowie Zerkleinerungsmeißeln und Gegenmeißeln, wobei Unterlage, Zerkleinerungsmeißel und Gegenmeißel derart beweglich sind, dass ein auf der Unterlage liegender zu zerkleinernder Polysilicium-Stab oder ein zu zerkleinerndes Polysilicium-Bruchstück zwischen den Meißeln derart justiert werden kann, dass alle Meißel im Bereich des Polysilicium-Stabs oder des Polysilicium-Bruchstücks Kontakt zum Polysilicium-Stab (Polysilicium-Bruchstück) besitzen und die Zerkleinerungsmeißel vor oder hinter dem Polysilicium-Stab (Polysilicium-Bruchstück) in ihrer Wirkachse weiter bis auf einen Sicherheitsabstand zum Gegenmeißel gefahren werden können. Eine derartige Vorrichtung ist beispielsweise in DE 10 2005 019 873 beschrieben.

Vorzugsweise umfasst die Vorrichtung zur Durchführung des erfindungsgemäßen Verfahrens auch Teilvorrichtungen zum Ausbauen und Transportieren.

Vorzugsweise bestehen alle Oberflächen der Teilanlagen, die mit Polysilicium in den einzelnen Bearbeitungsschritten in Kontakt kommen, aus einem nicht kontaminationsarmen Stahl, besonders bevorzugt aus einem niederlegierten Stahl.

Insbesondere bevorzugt bestehen die Teilvorrichtungen zum Ausbauen und die Brechwerkzeuge (z. B. die Handhammer, Brechschalen, Brech-Hämmer, Brechbacken), die Förderrinnen und Rutschen in einer optoelektronischen Trennanlage sowie die Siebbeläge aus einem nicht kontaminationsarmen Stahl, besonders bevorzugt einem niederlegierten Stahl. Diese Materialien führen zu einer gezielten Metallkontamination, welche mittels des beschriebenen Reinigungsprozesses schnell, einfach und in dem erforderlichen Maß entfernt werden kann.

Trotz dieser einfachen und kostengünstigen Ausführungsform und der damit verbundenen höheren Eingangskontamination des zerkleinerten klassierten Silicium-Bruchs, ermöglicht die Vorrichtung in Kombination mit einem Reinigungsprozess, wie er in DE 197 41 465 beschrieben ist, die Herstellung eines Polysilicium-Bruchs, der in allen Größenfraktionen Halbleiterqualität besitzt.

In einer anderen Ausführungsform der erfindungsgemäßen Vorrichtung besitzen alle mit Polysilicium in Kontakt kommenden Anlagenteile eine Oberfläche aus einem kontaminationsarmen Werkstoff oder sie bestehen aus einem kontaminationsarmen Werkstoff. Unter einem kontaminationsarmen Werkstoff ist vorzugsweise ein Werkstoff ausgewählt aus der Gruppe der Hartmetalle, Silicium und verschleißarmen Kunststoffe zu verstehen.

Als Hartmetall ist WC bevorzugt, besonders bevorzugt ein Hartmetallplattierung der produktberührten Anlagenteile, wie z. B. die Werkzeuge (Walzen, Brechplatten, Kegel) der Brecher, weiterhin kommt auch Titannitrid als Hartmetallwerkstoff zum Einsatz, als verschleißarme Kunststoffe sind Polyurethane, Polyethylen und PTFE bevorzugt verwendbar.

In Kombination mit dieser Vorrichtung muss die anschließende Reinigung des klassierten Polysilicium-Bruchs gezielt der jeweiligen Verunreinigung angepasst werden. So ist für eine Ausführungsform, bei der die Oberfläche der Vorrichtungen aus WC-Hartmetallen besteht, eine Reinigung mit folgender Zusammensetzung notwendig: 3,4 Gew% KH₂PO₄, 1,3 Gew% KOH und 3,3 Gew% K₃(FE(CN)₆) in vollentsalztem Wasser.
Fig. 1 zeigt die in Bsp. 2 verwendete Vorrichtung.
Fig. 2 zeigt die Ergebnisse der Fe-Bestimmung nach Reinigung aus Bsp. 2

Die folgenden Beispiele dienen der weiteren Erläuterung der Erfindung.

### Beispiel 1

In mehreren Ansätzen wurde der Einfluss von verschiedenen Bearbeitungswerkzeugen bzw. der Einfluss verschiedener, kontaminierender Materialien auf die Metalloberflächenwerte von Polysilicium-Bruchstücken untersucht.

Bsp. 1a: Ein Polysiliciumstab aus einem Siemens Reaktor wurde wie im Stand der Technik üblich, händisch kontaminationsarm mit einem Hammer aus Hartmetall (Wolframcarbid) zu Bruchstücken einer Kantenlänge von ca. 80 mm zerkleinert (Vergleichsbeispiel).

Bsp. 1b: Ein Polysiliciumstab aus einem Siemens Reaktor wurde mittels eines Walzenbrechers mit Brechschalen aus niedrig legiertem Werkzeugstahl (Gesamtlegierungsgehalt von < 5 Gew% der Elemente Cr, Co, Mn, Ni, Si, W, Al, Be, Cu, Mo, Nb, Pb, Ta, Ti, V, Zr, P, S, N, Ce und B). zu Bruchstücken einer Kantenlänge von ca. 80 mm zerkleinert.

Bsp. 1c: Die gemäß Bsp. 1a hergestellten Bruchstücke wurden zusätzlich mit Edelstahl, (V4A mit 18 % Chrom, 63 % Eisen, 2,5 % Mo, 13,5% Ni, 3 % sonstige Elemente) abgerieben, um das Fördern der Bruchstücke mit einer Förderrinne aus V4A Edelstahl zu simulieren (Vergleichsbeispiel).

Bsp. 1d: Ein Polysilicium-Stab aus einem Siemens Reaktor wurde mittels eines Backenbrechers mit Brechschalen aus Chromhartstahl (10 % Chrom, 89 % Eisen, 1 % sonstige Elemente) zu Bruchstücken einer Kantenlänge von ca. 80mm zerkleinert (Vergleichsbeispiel).

Aus der Gesamtmenge der oben beschriebenen hergestellten Polysilicium-Bruchstücke wurden jeweils Proben herausgezogen, die jeweils 20 typische Bruchstücke mit ca. 80 mm umfassten. Die Metalloberflächenwerte wurden mittels chemischen Ablösen der Oberfläche und anschließender Analyse der abgelösten Lösung mit ICPMS (Inductive-Coupled-Plasma-Mass-Spectroscopy) bestimmt. Tab. 1 gibt die Mittelwerte der Messung und damit die Eingangskontamination der Bruchstücke in eine nachfolgende Reinigung wieder.

**Tab. 1: Mittelwerte in pptw**

| **Bsp:** | **Fe** | **Cr** | **Ni** | **Na** | **Zn** | **Al** | **Cu** | **Mo** | **Ti** | **W** | **K** |
|---|---|---|---|---|---|---|---|---|---|---|---|
| **1a** | 2258 | 75 | 60 | 2087 | 224 | 440 | 45 | 17 | 64 | 1478 | 727 |
| **1b** | 839586 | 1545 | 1010 | 3045 | 846 | 725 | 2345 | 339 | 164 | 139 | 1491 |
| **1c** | 1250325 | 180234 | 35245 | 2750 | 650 | 340 | 3500 | 20 | 120 | 80 | 950 |
| **1d** | 950000 | 75000 | 85000 | 4300 | 270 | 265 | 650 | 35 | 145 | 60 | 1250 |

Diese Polysilicium-Bruchstücke wurden anschließend mit folgendem Prozess gereinigt:
1. Vorreinigung: 20 Minuten Beizen mit einer wässrigen HF/HCl/H₂O₂ Lösung enthaltend, neben Wasser, 5 Gew% HF, 8 Gew% HCl und 3 Gew % H₂O₂ bei 25 +/- 5 Grad. Der Siliciumätzabtrag betrug ca. 0,02 µm.
2. 5 Minuten Spülen bei 22 Grad.
3. Hauptreinigung: Ätzen 5 Min. bei 8 Grad in einer wässrigen HF/HNO₃ Lösung enthaltend, neben Wasser, 3 Gew% HF und 65 Gew% HNO₃. Der Ätzabtrag betrug ca. 12 µm.
4. 5 Minuten Spülen bei 22 Grad.
5. 5 Minuten Hydrophilierung in einer wässrigen HCl/H₂O₂ Lösung enthaltend, neben Wasser, 8 Gew% HCl und 2 Gew% H₂O₂ bei 22 Grad.
6. Spülen bei 22 Grad.
7. Trocknen mit Reinstluft Klasse 100 bei 80 Grad.

Mit diesem Reinigungsverfahren wurden die in Tab. 2 genannten Metalloberflächenwerte erhalten.

**Tab. 2 Mittelwerte in pptw aus der Bestimmung von je 20 Bruchstücken**

| Bsp | Fe | Cr | Ni | Na | Zn | Al | Cu | Mo | Ti | W | K |
|---|---|---|---|---|---|---|---|---|---|---|---|
| 1a | 28 | 4 | 2 | 40 | 13 | 58 | 2 | 1 | 22 | 21 | 15 |
| 1b | 26 | 7 | 8 | 38 | 26 | 36 | 5 | 1 | 19 | 6 | 16 |
| 1c | 63 | 18 | 8 | 36 | 23 | 45 | 9 | 1 | 23 | 6 | 21 |
| 1d | 125 | 135 | 10 | 31 | 23 | 38 | 3 | 2 | 19 | 4 | 19 |

### Ergebnis:

Die aus dem Stand der Technik bekannte Verwendung von kontaminationsarmen Werkstoffen, wie sie in Bsp. 1a beschrieben ist, liefert nach der Reinigung Polysilicium Bruch mit einer geringen metallischen Verunreinigung an der Oberfläche. Nachteiligerweise sind diese Werkstoffe nicht für alle Anlagenteile (z. B. Brechschalen mit Stacheln) technisch einsetzbar. Wenn herstellbar, sind derartige Anlagenteile sehr teuer und damit nicht wirtschaftlich. Zudem wird Hartmetall (Wolframcarbid) von dem Prozess schlechter aufgelöst, sichtbar an den etwas erhöhten Wolframwerten für Bsp. 1a in Tab. 1.

Der aus dem Stand der Technik bekannte Einsatz von Edelstahl oder Chromhartstahlwerkzeugen zum Zerkleinern von PolysiliciumBruch, wie in Bsp. 1c und 1d beschrieben, liefert nach der Reinigung Polysilicium-Bruch mit erhöhten Eisen und Chromwerten. Als Zerkleinerungswerkstoff für obig beschriebene Reinigung sind derartige Werkstoffe trotz ihrer, gegenüber niedriglegierten Stählen (Beispiel 1b), höheren Härte und Korrosionsbeständigkeit daher z. B. auch für (kurze) Förderrinnen nicht geeignet.

Die in Bsp. 1 b beschriebene Verwendung von Brechwerkzeugen aus einem niedriglegierten Werkzeugstahl mit Legierungsgehalten kleiner 5 % führen zwar zu einer stärkeren Verunreinigung des Polysilicium-Bruchs und damit höheren Eingangskontamination in der Reinigung, diese Verunreinigungen lassen sich aber durch die genannte Reinigung auf die gleichen niedrigen Werte vermindern, wie sie bei der Zerkleinerung mit nach Stand der Technik bekannten kontaminationsarmen Handverfahren erreicht wird (1a).

Im Unterschied zu Beispiel 1a ist damit bei einer erfindungsgemäßen Abstimmung von Reinigungsverfahren für das zerkleinerte und klassierte Silicium und Materialwahl der Vorrichtung zur Zerkleinerung, Förderung und Klassierung, eine kostengünstige maschinelle Zerkleinerung möglich, wobei zudem ein kostengünstiger und verfahrenstechnisch vielseitig (z. B. für Brechbacken) einsetzbarer Werkzeugstahl zum Einsatz kommen kann.

### Beispiel 2

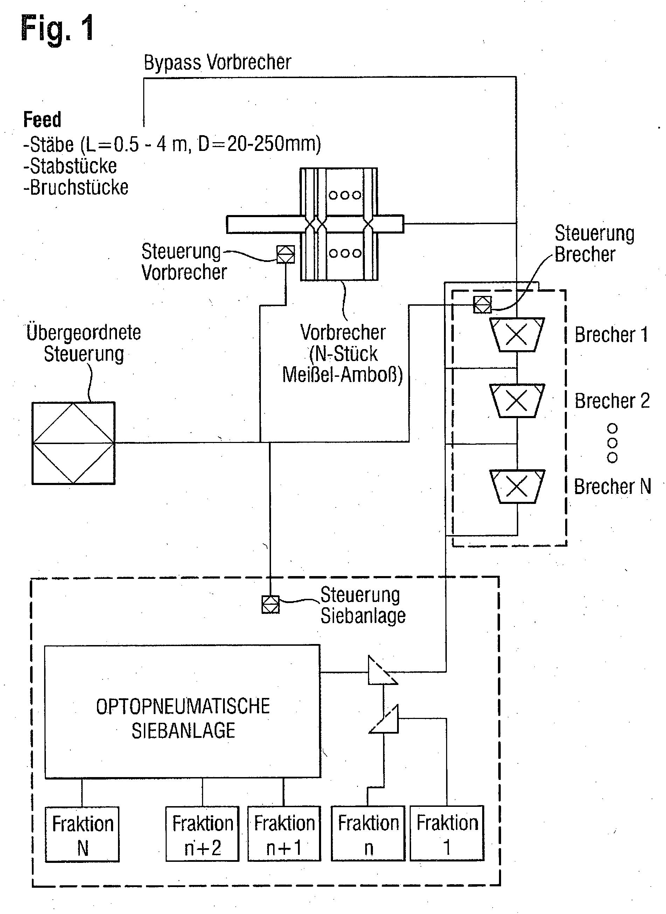

Ein Polysiliciumstab aus einem Siemens Reaktor wurde mittels einer Vorrichtung gemäß Fig. 1 zu Polysiliciumbruch zerkleinert und in verschieden Größen sortiert, wobei alle in das Produkt kontaminierenden Anlagenteile aus niedriglegiertem Stahl, wie in Bespiel 1b beschrieben, ausgeführt sind.

Bei den mit dem Produkt in Kontakt kommenden Anlagenteilen handelte es sich um die Meißel, die die Unterlage bildenden Halbschalen des Vorzerkleinerers, die Brechschalen und Auskleidungen des Walzenbrechers, alle Förderrinnen sowie die Auskleidungen in den mechanischen Sieben und in den optopneumatischen Sortiermodulen.

Der so hergestellte Poly-Si-Bruch mit einer max. Kantenlänge von 250 mm wurde anschließend in einer Reinigungsanlage, wie in DE 197 41 465 beschrieben, und im Folgenden zusammengefasst gereinigt:
1. Vorreinigung: 20 Minuten Beizen mit einer wässrigen HF/HCl/H₂O₂ Lösung enthaltend, neben Wasser, 5 Gew% HF, 8 Gew% HCl und 3 Gew % H₂O₂ bei 25 +/- 5 Grad. Der Siliciumätzabtrag betrug ca. 0,02 µm
2. 5 Min. Spülen bei 22 Grad.
3. Hauptreinigung: Ätzen 5 Min. bei 8 Grad in einer wässrigen HF/HNO₃ Lösung enthaltend, neben Wasser, 3 Gew% HF und 65 Gew% HNO₃. Der Ätzabtrag betrug ca. 12 µm.
4. 5 Min. Spülen.
5. 5 Minuten Hydrophilierung in einer wässrigen HCl/H₂O₂ Lösung enthaltend, neben Wasser, 8 Gew% HCl und 2 Gew% H₂O₂ bei 22 Grad.
6. Spülen bei 22 Grad.
7. Trocknen mit Reinstluft Klasse 100 bei 80 Grad.

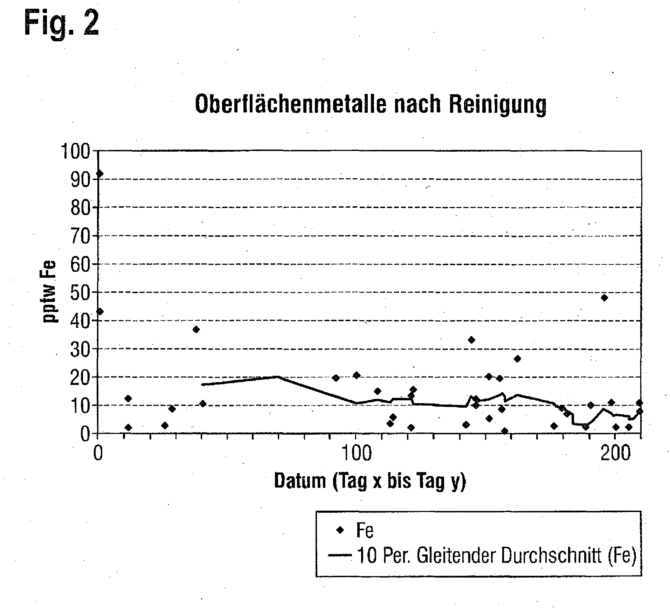

Trotz der Verwendung des "nicht kontaminationsarmen" Materials (niedrig legierter Werkzeugstahl) und einer gegenüber herkömmlichen Methoden um mehr als Faktor 100 höheren Eingangskontamination in die Reinigung (siehe Fe-Werte von Beispiel 1a zu 1b in Tab. 1) wurde überraschenderweise durch obige Reinigung die gewünschten Reinheit erzielt. Es wurde in verschiedenen Zeitabständen je eine Stichprobe (=Bruchstück mit ca. 80 mm) mittels oben bereits beschriebener Methode auf metallische Verunreinigungen hin untersucht. Das Ergebnis dieser Messungen ist in Fig. 2 dargestellt. Auch die übrigen metallischen Verunreinigungen lagen auf dem in Fig. 2 für Fe dargestellten (halbleitertauglichen) Niveau.

## Patentansprüche

1. Verfahren zur Herstellung von hochreinem klassierten Polysilicium-Bruch, bei dem ein Polysilicium aus dem Siemens-Verfahren mittels einer Vorrichtung umfassend Zerkleinerungswerkzeuge und einer Siebvorrichtung zerkleinert und klassiert wird und der so erhaltene Polysilicium-Bruch mittels eines Reinigungsbades gereinigt wird, **dadurch gekennzeichnet, dass** die Zerkleinerungswerkzeuge und die Siebvorrichtung durchgängig eine mit dem Polysilicium in Kontakt kommende Oberfläche aus einem niedriglegierten Stahl besitzen, und der Polysilicium-Bruch nur mit solchen Fremdpartikeln verunreinigt wird, welche anschließend gezielt durch das Reinigungsbad entfernt werden.

2. Verfahren nach Anspruch 1, **dadurch gekennzeichnet, dass** die Oberfläche aller zum Brechen, Fördern/Transportieren, und Klassieren des Polysiliciums verwendeten Vorrichtungen, die mit dem Polysilicium in Berührung kommt, durchgängig aus niedriglegiertem Stahl besteht.

3. Verfahren nach Anspruch 1 oder nach Anspruch 2, **dadurch gekennzeichnet, dass** der niedriglegierten Stahl einen Legierungsgehalt von kleiner als 5 Gew.% aufweist.

4. Verfahren nach einem der Ansprüche 1 bis 3, **dadurch gekennzeichnet, dass** das Reinigungsbad
eine Vorreinigung in zumindest einer Stufe mit einer oxidierenden Reinigungslösung, die die Verbindungen Fluorwasserstoffsäure, Chlorwasserstoffsäure und Wasserstoffperoxid enthält,
eine Hauptreinigung in einer weiteren Stufe mit einer Reinigungslösung, die Salpetersäure und Fluorwasserstoffsäure enthält,
und eine Hydrophilierung des Polysilicium-Bruchs mittels einer weiteren Stufe mit einer oxidierenden Reinigungslösung umfasst.

5. Vorrichtung zur Durchführung des Verfahrens gemäß einem der Ansprüche 1 bis 4, umfassend Teilvorrichtungen zum Brechen, Fördern, Klassieren und Reinigen von Polysilicium, bei dem die Oberfläche aller zum Brechen, Fördern, und Klassieren des Polysiliciums verwendeten Teilvorrichtungen durchgängig aus niedriglegiertem Stahl besteht.

6. Vorrichtung gemäß Anspruch 5, **dadurch gekennzeichnet, dass** sie eine Aufgabeeinrichtung für den Polysilicium-Grobbruch in eine Brecheranlage, die Brecheranlage, eine Fördervorrichtung von der Brecheranlage zu einer Sortieranlage und die Sortieranlage zum Klassieren des Polysilicium-Bruchs umfasst.

7. Vorrichtung gemäß Anspruch 6, **dadurch gekennzeichnet, dass** die Brechanlage einen Walzenbrecher oder einen Backenbrecher, bevorzugt einen Walzenbrecher, besonders bevorzugt einen Stachelwalzenbrecher umfasst.

8. Vorrichtung gemäß Anspruch 6 oder 7, **dadurch gekennzeichnet, dass** die Sortieranlage aus einer mehrstufigen mechanischen Siebanlage und einer mehrstufigen optoelektronische Trennanlage besteht.

9. Vorrichtung gemäß einem der Ansprüche 5 bis 8, **dadurch gekennzeichnet, dass** sie einen Vorzerkleinerer umfasst.

## Claims

1. Method for producing highly pure classified polysilicon fragments, in which polysilicon from the Siemens method is comminuted and classified by means of a device comprising comminution tools and a screening device, and the polysilicon fragments thus obtained are cleaned by means of a cleaning bath, **characterized in that** the comminution tools and the screening device essentially have a surface, coming in contact with the polysilicon, consisting of a low-alloy steel, and the polysilicon fragments are contaminated only with extraneous particles that are subsequently removed selectively by the cleaning bath.

2. Method according to Claim 1, **characterized in that** the surface of all devices used for crushing, delivering/transporting and classifying the polysilicon, which comes in contact with the polysilicon, consists essentially of low-alloy steel.

3. Method according to Claim 1 or according to Claim 2, **characterized in that** the low-alloy steel has an alloy content of less than 5% by weight.

4. Method according to one of Claims 1 to 3, **characterized in that** the cleaning bath comprises
pre-cleaning in at least one stage with an oxidizing cleaning solution which contains the compounds hydrofluoric acid, hydrochloric acid and hydrogen peroxide,
main cleaning in a further stage with a cleaning solution which contains nitric acid and hydrofluoric acid,
and hydrophilization of the polysilicon fragments by means of a further stage with an oxidizing cleaning solution.

5. Device for carrying out the method according to one of Claims 1 to 4, comprising device subunits for crushing, delivering, classifying and cleaning polysilicon, wherein the surface of all device subunits used for crushing, delivering and classifying the polysilicon consists essentially of low-alloy steel.

6. Device according to Claim 5, **characterized in that** it comprises an instrument for feeding the coarse polysilicon fragments into a crusher system, the crusher system, an instrument for delivery from the crusher system to a sorting system, and the sorting system for classifying the polysilicon fragments.

7. Device according to Claim 6, **characterized in that** the crushing system comprises a roll crusher or a jaw crusher, preferably a roll crusher, particularly preferably a spiked roll crusher.

8. Device according to Claim 6 or 7, **characterized in that** the sorting system consists of a multistage mechanical screening system and a multistage optoelectronic separating system.

9. Device according to one of Claims 5 to 8, **characterized in that** it comprises a pre-comminuter.

## Revendications

1. Procédé de fabrication de mitrailles classées de polysilicium de haute pureté, dans lequel un polysilicium provenant du procédé Siemens est fractionné et classé au moyen d'un dispositif qui comprend des outils de fractionnement et un dispositif de tamisage, les mitrailles de polysilicium ainsi obtenues étant épurées au moyen d'un bain d'épuration,
**caractérisé en ce que**
les outils de fractionnement et le dispositif de tamisage possèdent généralement une surface en acier peu allié qui entre en contact avec le polysilicium, les mitrailles de polysilicium n'étant contaminées que par des particules étrangères qui sont ensuite enlevées de manière contrôlée par le bain d'épuration.

2. Procédé selon la revendication 1, **caractérisé en ce que** la surface de tous les dispositifs utilisés pour rompre, transporter et trier le polysilicium et qui entrent en contact avec le polysilicium sont généralement constitués d'acier peu allié.

3. Procédé selon la revendication 1 ou 2, **caractérisé en ce que** l'acier peu allié présente une teneur en éléments d'alliage inférieure à 5 % en poids.

4. Procédé selon l'une des revendications 1 à 3, **caractérisé en ce que** le bain d'épuration présente
une pré-épuration en au moins une étape à l'aide d'une solution oxydante d'épuration qui contient les composés acide fluorhydrique, acide chlorhydrique et peroxyde d'hydrogène,
une épuration principale dans une autre étape à l'aide d'une solution d'épuration qui contient de l'acide nitrique et de l'acide fluorhydrique et
une hydrophilisation des mitrailles de polysilicium au moyen d'une autre étape réalisée à l'aide d'une solution oxydante d'épuration.

5. Dispositif en vue de l'exécution du procédé selon l'une des revendications 1 à 4, le dispositif comportant des dispositifs partiels de fractionnement, transport, tri et épuration de polysilicium et dans lequel la surface de tous les dispositifs partiels utilisés pour le fractionnement, le transport et le tri du polysilicium est généralement constituée d'acier peu allié.

6. Dispositif selon la revendication 5, **caractérisé en ce qu'**il présente un dispositif d'admission de mitrailles grossières de polysilicium dans une installation de fractionnement, l'installation de fractionnement, un dispositif de transport qui conduit de l'installation de fractionnement à une installation de tri et l'installation de tri qui classifie les mitrailles de polysilicium.

7. Dispositif selon la revendication 6, **caractérisé en ce que** l'installation de fractionnement comporte un fractionneur à cylindre ou un fractionneur à mâchoires, de préférence un fractionneur à cylindre et de façon particulièrement préféré un fractionneur à cylindre à dents.

8. Dispositif selon les revendications 6 ou 7, **caractérisé en ce que** l'installation de tri est constituée d'une installation mécanique de tri à plusieurs étages et d'une installation optoélectronique de séparation à plusieurs étages.

9. Dispositif selon l'une des revendications 5 à 8, **caractérisé en ce qu'**il comporte un pré-fractionneur.
